# EUROPÄISCHE PATENTSCHRIFT

(11) **EP 2 849 204 B1**
(45) Veröffentlichungstag und Bekanntmachung des Hinweises auf die Patenterteilung: **29.11.2017**
(21) Anmeldenummer: 13184184.3
(22) Anmeldetag: 12.09.2013
(51) Int. Cl.: H01J 37/32

(54) **Plasmaerzeugungsvorrichtung**
Plasma generating apparatus
Dispositif de production de plasma

(43) Veröffentlichungstag der Anmeldung: 18.03.2015
(73) Patentinhaber: Meyer Burger (Germany) AG, 09337 Hohenstein-Ernstthal (DE)
(72) Erfinder: Mai, Joachim, 04603 Nobitz (DE)
(74) Vertreter: Kailuweit & Uhlemann Patentanwälte Partnerschaft mbB

(56) Entgegenhaltungen:
- WO-A1-2010/108847
- WO-A2-2008/010943
- DE-B4- 10 358 505
- US-A1- 2004 060 517
- US-A1- 2013 087 531

## Beschreibung

Die Erfindung betrifft eine Plasmaquelle, die die Vorteile von induktiv und von kapazitiv gekoppeltem Plasma verbindet.

Induktiv gekoppelte Plasmen (ICP) erreichen eine hohe lonendichte bei niedrigem Plasmapotential. Darüber hinaus können auch großflächige Plasmen geschaffen werden. In Verbindung mit einer besonders einfachen Plasmaerzeugung ermöglicht dies eine wirtschaftliche Betriebsweise der Plasmaquellen.

Kapazitive gekoppelte Plasmen (CCP) weisen wegen der niedrigeren Anregungs- und Rotationstemperaturen eine niedrigere Zündtemperatur auf. Aufgrund der leichten Handhabbarkeit und der Stabilität kann kapazitiv gekoppeltes Plasma für eine Vielzahl von Anwendungen, unter anderem in Aerosolen oder nassen Gasen, eingesetzt werden, bei denen andere Plasmen unter Umständen erlöschen würden. Besonders gut geeignet ist die CCP-Kopplung, um Ionen im Plasma zu beschleunigen und für Bearbeitungsprozesse zu extrahieren.

Beide Plasmaerzeugungsformen haben somit ihre Vorteile und Existenzberechtigung in der Technik.

In der DE 103 58 505 B4 wird eine ICP-Quelle beschrieben, die eine magnetische Polschuhanordnung aufweist, wobei die Erregerspulen in Nuten der Pohlschuhe angeordnet sind. Die Polschuhe bewirken eine Konzentration der Magnetfelder der Erregerspulen unterhalb der Polschuhe, in dem für die Plasmazündung vorgesehenen Bereich. Beiderseits und linear zu den magnetischen Polschuhen sind weitere Permanent-Magnete als Multipolmagnetanordnung vorgesehen. Bei diesem Aufbau überlagern sich die Magnetfelder der Multipolanordnung mit dem induktiv gekoppelten Plasma. Der beschriebene Aufbau ist insbesondere für langestreckte, flächige Plasmaquellen geeignet, wie sie für die Solarzellenherstellung im Durchlaufverfahren bevorzugt eingesetzt werden.

Die EP 0 908 923 B1 beschreibt eine Plasmaquelle, bei der der Magnetkern (Ferritkern), der zur Konzentration des Magnetfeldes im Plasmaraum dient, auch gleichzeitig als Verschluss der Anschlussöffnung der Plasmaquelle an die Behandlungskammer genutzt wird. Bevorzugte Ausführungsformen der Plasmaquelle sind rotationssymmetrisch. Es kommen keine Multipolmagnetanordnungen zum Einsatz, um im Plasma Whistler-Wellen zu erzeugen.

Bekannte Bauformen von ICP-Quellen weisen nicht die vorteilhaften Eigenschaften von CCP-Quellen auf.

Jedoch sind bereits Plasmaerzeugungsvorrichtungen bekannt, die kapazitive und induktive Elemente miteinander verbinden.

So wird in der WO 2010/108847 A1 eine Vorrichtung zur Plasmaerzeugung beschrieben, die neben einer induktiven Vorrichtung auch eine kapazitive Vorrichtung zur Einkopplung von Energie in ein Plasma in einem Plasmaraum aufweist. Dabei ist die erste Elektrode der kapazitiven Vorrichtung als Lochplatte ausgeführt, deren Lochstruktur zur induktiven Vorrichtung zentriert ausgebildet ist. Die induktive Vorrichtung und die kapazitive Vorrichtung werden getrennt voneinander mit Energie versorgt - entweder durch unterschiedliche Frequenzgeneratoren oder durch einen gemeinsamen Frequenzgenerator.

Die WO 2008/010943 A2 beschreibt eine Plasmaerzeugungsvorrichtung, bei der eine kapazitive Vorrichtung in lateraler Richtung von einer induktiven Vorrichtung eingefasst ist, wobei die kapazitive und die induktive Vorrichtung von unterschiedlichen Frequenzgeneratoren mit Energie versorgt werden. Die induktive Vorrichtung begrenzt die Ausdehnung des durch die kapazitive Vorrichtung erzeugten Plasmas in lateraler Richtung.

Auch die US 2013/087531 A1 beschreibt eine Plasmaerzeugungsvorrichtung, die eine induktive Kopplung mit einer kapazitiven Kopplung kombiniert, wobei beide Vorrichtungen getrennt durch einen Frequenzgenerator gespeist werden.

Es stellt sich daher die Aufgabe, ein Plasmaquelle zu schaffen, die die Vorteile der ICP und der CCP-Plasmen in sich vereint.

Erfindungsgemäß wird die Aufgabe mit einer Vorrichtung nach Anspruch 1 gelöst. Vorteilhafte Ausführungsformen sind in den rückbezogenen Unteransprüchen dargestellt.

Die erfindungsgemäße Vorrichtung zeichnet sich dadurch aus, dass zeitgleich induktiv und kapazitiv Energie in das Plasma eingekoppelt wird.

Erfindungsgemäß ist vorgesehen, dass die Vorrichtung mindestens eine Spule zur induktiven Einkopplung von Energie in das Plasma aufweist. Das Plasma wird dabei in dem dafür vorgesehenen Raumgebiet, dem Plasmaraum, erzeugt. Die Spule ist bevorzugt in einer Nut eines magnetischen Polschuhes angeordnet, wobei die Öffnung der Nut (Nutseite) dem Plasma (Plasmaraum) zugewandt ist. Die Spulen sind dabei bevorzugt in Isolierkörper (keramisch) eingebettet. Die Anordnung aus Polschuhen und Spulen ist in einer elektrisch leitfähigen Umhüllung angeordnet, die diese vollständig, mit Ausnahme der Nutseite der Polschuhe und der Spulenanschlüsse, umschließt. Die Nutseite ist mit einem elektrisch leitfähigen faradayschen Schirm abgedeckt. Dieser schließt das Innere der Umhüllung gegen den Plasmaraum ab und ist mit der leitfähigen Umhüllung leitend verbunden, wobei die Magnetfelder der Spulen zur induktiven Kopplung austreten können, jedoch elektrische Felder zuverlässig abgeschirmt werden bzw. das Durchdringen elektrischer Felder durch den faradayschen Schirm weitestgehend reduziert wird. Zwischen dem faradayschen Schirm und der magnetischen Polschuhanordnung kann auch eine zusätzliche Isolierplatte aus einem magnetfelddurchlässigen Material eingesetzt werden, die als Verkapselung bzw. Schutz der Polschuhanordnung dienen kann. Diese Verkapselung kann gegenüber der leitfähigen Umhüllung auch vakuumdicht ausgeführt werden, um eventuelle Verunreinigungen in den Prozessraum vermeiden zu können, bzw. auch im Prozessraum vorhandene reaktive Gase oder Gasfragmente von der Polschuhanordnung fernzuhalten. Der Innenraum innerhalb der Umhüllung kann dabei einen separat gepumpten Vakuumraum bilden oder mit der Atmosphäre oder einer Schutzgasvorrichtung verbunden sein. Als Gegenstück zum faradayschen Schirm existiert eine Gegenelektrode, mit welcher der faradaysche Schirm eine Kondensatoranordnung ausbildet. Die Gegenelektrode ist bevorzugt auf der dem faradayschen Schirm gegenüberliegenden Seite, weiterhin bevorzugt hinter dem zu behandelnden Substrat angeordnet. Außerhalb der Umhüllung, elektrisch isoliert von dieser und diese mit Ausnahme der Nutseite und von Anschlussdurchführungen umschließend, ist eine leitfähige Wand als sogenannte Dunkelraumabschirmung angeordnet. Bevorzugt wird die Dunkelraumabschirmung auf das Massenpotential der Anordnung gelegt. Weiterhin bevorzugt ist die Nutseite der Dunkelraumabschirmung mit einer Abdeckung aus einem nichtleitenden Material (dielektrische Abdeckung) versehen. Zweck der Dunkelraumabschirmung ist es, die Entstehung von Plasma auf den Plasmaraum zu begrenzen. Zur Energieeinspeisung in das Plasma ist die mindestens eine Spule mit einem Frequenzgenerator, bevorzugt einem Hochfrequenzgenerator verbunden. Ein weiterer Frequenzgenerator ist an die Umhüllung und den mit dieser verbundenen faradayschen Schirm angeschlossen. Die beiden anderen Pole der Frequenzgeneratoren liegen vorzugsweise auf Massepotential.

Bevorzugt werden parallel zu der bzw. den Spulen Multipolmagnetanordnungen so angeordnet, dass sich das Magnetfeld der Multipolmagnetanordnungen mit dem der Spulen im Plasma überlagert. Die Multipolmagnetanordnungen sind vorzugsweise so ausgerichtet, dass sie zur Erzeugung sogenannter Whistler-Wellen beitragen. Die Whistlerwellen verlaufen in einer Plasmarandschicht entlang der Oberfläche des Plasmas und verbessern den Energieeintrag in dieses. Um dies zu erreichen sind die Multipolmagnetanordnungen vorzugsweise anziehend zueinander ausgerichtet. Sie bilden gemeinsam mit dem Magnetfeld der Spulen eine Art magnetische Flasche, die das Plasma vorteilhaft einschließt und formt. Die Multipolmagnetanordnungen sind bevorzugt außerhalb der Dunkelraumabschirmung angeordnet. Sie werden dabei bevorzugt neben der Dunkelraumabschirmung, in Richtung Plasmaraum auf Höhe der dielektrischen Abdeckung, mit dieser abschließend, oder aber in einer weiteren bevorzugten Ausführungsform, neben dem Plasmaraum angeordnet.

Zusammenfassend weist somit erfindungsgemäß eine Anordnung nach DE 103 58 505 B4 eine Umhüllung mit einem faradayschen Schirm in Richtung des Plasmaraumes auf und ist weiterhin mit einer Dunkelraumabschirmung versehen. Neben der induktiven Energieeinkopplung des Vorrichtungsteils nach DE 103 58 505 B4 erfolgt eine kapazitive Energieeinkopplung in das Plasma über die zusätzlich vorgesehene Umhüllung bzw. den faradayschen Schirm, welche die Vorrichtung nach DE 103 58 505 B4 umgeben.

Die Umhüllung wird bevorzugt gekühlt. Dies erfolgt bspw. mittels Kühlmitteldurchleitung. Auch andere Bauteile können bei Bedarf mit Kühlmitteldurchleitungen oder sonstiger konvektiver bzw. konduktiver Wärmeabfuhr versehen sein.

Die ICP-Spulen zur induktiven Energieeinkopplung in das Plasma sind vorzugsweise paarweise, linear erstreckt und parallel verlaufend vorgesehen. Die Energieeinkopplung erfolgt dann aus Symmetriegründen an den entgegengesetzten Enden der Spulen des Paares. Vorteilhaft sind in einer Plasmaerzeugungsvorrichtung mehrere Spulenpaare parallel zueinander angeordnet. Es sind jedoch auch andere Spulenkonfigurationen möglich, bspw. kreisförmige oder wellenförmige Anordnungen. Bei besonders langgestreckten Konstruktionen können einzelne ICP-Spulen mit zusätzlichen Energiezuführungen versehen sein. Auch eine verschachtelte Anordnung von Spulen ist möglich.

Der faradaysche Schirm besteht aus einem leitfähigen, bevorzugt metallischen Material. Er weist Öffnungen zum Austritt der Magnetfeldlinien der ICP-Spulen aus der Umhüllung auf. Die Öffnungen verlaufen bevorzugt parallel zu den Magnetfeldlinien, um diese möglichst wenig zu beeinflussen. Die Öffnungen sind daher vorzugsweise schlitzartig gestaltet. Eine bevorzugte Ausführungsform sieht ein rechteckförmiges Blech als faradayschen Schirm vor, bei dem abwechselnd von den langen Seiten des Blechs aus Schlitze in dieses hinein, bis fast zur gegenüberliegenden Seite reichen. Auf diese Weise entsteht eine mäanderartige Struktur, die dazu beiträgt, die Bildung von Wirbelströmen im faradayschen Schirm zu reduzieren bzw. zu unterdrücken. Weitere Ausführungsformen des faradayschen Schirmes sind möglich und für den Fachmann ausführbar, wobei wesentlich ist, dass die Öffnungen zum Austritt der Magnetfeldlinien vorzugsweise parallel zu diesen verlaufen sollen.

Die Dunkelraumabschirmung ist leitfähig und verhindert, dass außerhalb des dafür vorgesehenen Bereichs durch die kapazitive Energieeinspeisung über die Umhüllung ein proprietäres Plasma zündet. Die Dunkelraumabschirmung wird dazu bevorzugt auf Massepotential gelegt.

Zwischen faradayschem Schirm und Plasma befindet sich bevorzugt, als Abschluss der Dunkelraumabschirmung und als Verschmutzungsschutz, zum Plasmaraum gerichtet, die dielektrische Abdeckung, bspw. aus Quarzmaterial oder Aluminiumoxidkeramik.

Das entstehende Plasma ist weitestgehend potentialfrei gegenüber allen Wänden der Plasmabehandlungskammer.

In der erfindungsgemäßen Vorrichtung wird die Dichte des Plasmas überwiegend durch die induktive Energieeinkopplung bestimmt. Dessen Bewegung (Beschleunigungsbewegung der Ionen) ist jedoch weitgehend durch die kapazitive Einkopplung definiert. Die Anregungsfrequenzen und Energiebeiträge der ICP- und der CCP-Energieeinspeisung in das Plasma können vorteilhaft getrennt voneinander festgelegt bzw. geändert werden. Darüber hinaus ist aber auch eine phasensynchronisierte Anregung möglich. Zur Versorgung mit Energie können geeignete HF- oder LF-Generatoren (Hoch- oder Niederfrequenzgeneratoren) nach dem Stand der Technik eingesetzt werden. Die Frequenzen der induktiven Einkopplung liegen bevorzugt im Bereich von 100 kHz bis 13,56 MHz und können dabei auch gepulst bereitgestellt werden. Die kapazitive Einkopplung lässt Anregungsfrequenzen im Bereich von Gleichstrom (0 Hz) bis mehrere MHz, bevorzugt von 40 kHz bis 400 kHz zu. Auch hier können diese Frequenzen gepulst oder kontinuierlich bereitgestellt werden.

Die Gaszufuhr zur Plasmaerzeugungsvorrichtung erfolgt bevorzugt getrennt von dieser seitlich, neben dem Plasmaraum. Optional ist auch eine Gasabsaugung vorgesehen.

Die Abmessung der erfindungsgemäßen Vorrichtung und damit auch des erzeugten Plasmas sind ohne weiteres skalierbar.

Die erfindungsgemäße Vorrichtung ermöglicht eine lineare Skalierung der Leistung der Plasmaquelle bis hin zum Hochratenbereich, ohne dass es zu Stehwellenproblemen käme. Zum Erreichen höchster Plasmadichten ist keine Höchstfrequenztechnik erforderlich, wie es nach dem Stand der Technik mit VHF bei Parallelplattenanordnungen notwendig ist.

Die erfindungsgemäße Vorrichtung wird bevorzugt im Druckbereich von 5*10⁻⁴ mbar bis 0,1 mbar eingesetzt.

Eine vorteilhafte Anwendung der erfindungsgemäßen Plasmaerzeugungsvorrichtung liegt in der Solarzellenherstellung. Hier werden die flächig ausgedehnten Substrate bzw. die darauf angeordneten Schichten häufig einer Plasmabehandlung unterzogen. Dabei werden diese entweder durch eine Behandlungskammer hindurchbewegt oder in einer solchen angeordnet. Besonders vorteilhaft ist es, wenn die Plasmaerzeugungsvorrichtung über die gesamte Breite des ggf. bewegten Substrates ein gleichmäßiges Plasma bereitstellt. Vorteilhaft ist es daher, die Abmessungen der Spulen an die Abmessungen des zu behandelnden Substrates anzupassen und die Spulen mindestens so lang auszuführen, wie das unter ihnen bewegte Substrat breit ist. Vorteilhaft übersteigt die Länge der Spulen die Breite des Substrates etwas, um Randeffekte zu unterdrücken.

Ein weiteres Anwendungsgebiet liegt in der Beschichtung weiterer, bevorzugt flächiger Körper, bspw. von Folien.

Aufgrund der positiven Eigenschaft, dass die induktive Energieeinspeisung neben dem faradayschen Schirm und der Dunkelraumabdeckung auch Wandungen von Behandlungskammern durchdringen kann, kann die Vorrichtung innerhalb einer Behandlungskammer angeordnet werden, wobei die Multipolmagnetanordnungen innerhalb oder außerhalb der Behandlungskammer angeordnet sein können, oder aber die Vorrichtung ist innerhalb der Behandlungskammer angeordnet, wobei die Multipolmagnetanordnungen neben der Dunkelraumabdeckung oder aber neben dem Plasmaraum liegen.

Durch die Einhüllung der ICP-Anordnung mit leitfähigen Wänden (Umhüllung und faradayscher Schirm) kann die vorhandene kapazitive Kopplung auch als Zündhilfe für das induktiv gekoppelte Plasma genutzt werden. Dafür wird in einer bevorzugten Ausführungsform zusätzlich zur HF- Leistungsversorgung der ICP-Anordnung, für eine kurze definierte Zeit, die bevorzugt im Bereich von wenigen Millisekunden bis zu einigen 100 ms, besonders bevorzugt im Bereich von 2 ms bis 800 ms, liegt, eine erhöhte HF-Spannung an die kapazitiv gekoppelte Anordnung angelegt. Nach erfolgter Zündung des induktiv gekoppelten Plasmas kann die HF- Leistungsversorgung des kapazitiv gekoppelten Plasmas entweder auf Massepotential oder bestimmungsgemäß mit einer definierten HF-Leistung weiter betrieben werden.

Die erfindungsgemäße Vorrichtung kann auch als eigenständige rein induktiv gekoppelte Plasmaquelle, also ohne die kapazitive Kopplung betrieben werden. Für eine sichere Plasmazündung des induktiven Plasmas kann dann zum Beispiel die für die Zündung kurzzeitig erforderliche HF- Spannung, vorteilhaft auch aus der HF-Leistungsversorgung für die induktive Kopplung mit abgeleitet werden. Das erfolgt vorzugsweise mit einem HF-Schalter.

Diese Vorgehensweise wird bevorzugt bei einem bereits optimierten Anwendungsfall zur Einsparung einer sonst separaten HF-Leistungsversorgung für die kapazitive Koppelanordnung genutzt. Der notwendige HF-Leistungsbedarf für das kapazitiv gekoppelte Plasma wird dann vorteilhaft über feste oder einstellbare HF-Leistungsteiler aus der HF-Leistungsversorgung des induktiv gekoppelten Plasmas mit versorgt.

Im Folgenden wird die Erfindung anhand verschiedener Abbildungen erläutert, ohne dass sie auf diese Ausführungsbeispiele begrenzt werden soll.

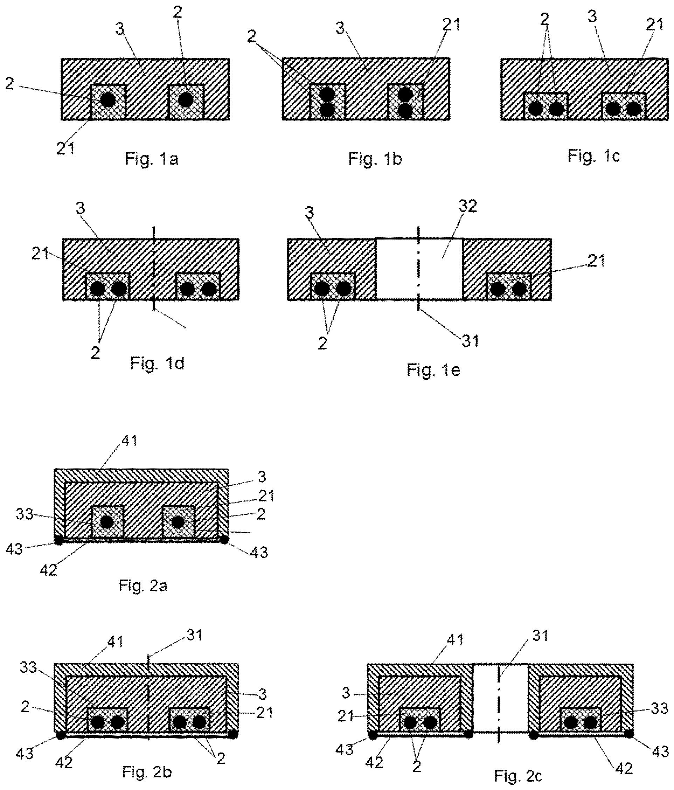

**Fig. 1a bis Fig. 1e** zeigen Anordnungsvarianten der ICP-Spulen (2) in den magnetischen Polschuhanordnungen (3). Die Spulen (2) verlaufen linear, senkrecht zur Zeichenfläche. Sie sind in keramische Isolierkörper (21) eingebettet. In Fig. 1a sind zwei Spulen (2) mit jeweils eigenen keramischen Isolierkörpern (21) vorgesehen. Der Anschluss der Spulen (2) erfolgt an entgegengesetzten Enden, d.h. die erste Spule (2) wird unterhalb der Zeichnungsebene mit Hochfrequenz beaufschlagt, während die bei der zweiten oberhalb der Zeichnungsebene passiert, bzw. umgekehrt.

In den Figuren Fig. 1b und Fig. 1c sind die Spulen (2) paarweise in den keramischen Isolierkörpern (21) angeordnet. Auch hier sind die Anschlüsse bei jedem Spulenpaar entgegengesetzt ausgeführt.

In den Figuren **Fig. 1d** und **Fig. 1e** sind rotationssymmetrische Ausführungen von Spulenanordnungen dargestellt. Die Spulenachsen verlaufen dabei auf konzentrischen Kreisbahnen.

Die Figuren **Fig. 2a bis Fig. 2c** zeigen die Anordnungen aus den Figuren Fig. 1a sowie Fig. 1d und Fig. 1e mit der leitfähigen Umhüllung, die aus der Umhüllung (41) im Bereich der magnetischen Polschuhanordnung (3) sowie dem faradayschen Schirm (42) im Nutenbereich der Polschuhanordnung besteht. Zwischen der Umhüllung (41) und dem faradayschen Schirm (42) besteht ein (hier schematisch dargestellter) leitfähiger Kontakt (43). Die Nuten (33) sind hier nochmals gesondert gekennzeichnet. Der Nutenbereich ist somit die Seite der Polschuhanordnung (3), auf der sich die Nuten (33) zum Einsatz der keramischen Isolierkörper (21) mit den Spulen (2) befinden. Analoge Ausgestaltungen sind auch für die runden Ausführungsformen (kenntlich anhand der Achsen (31) in den Figuren Fig. 2b und Fig. 2c möglich.

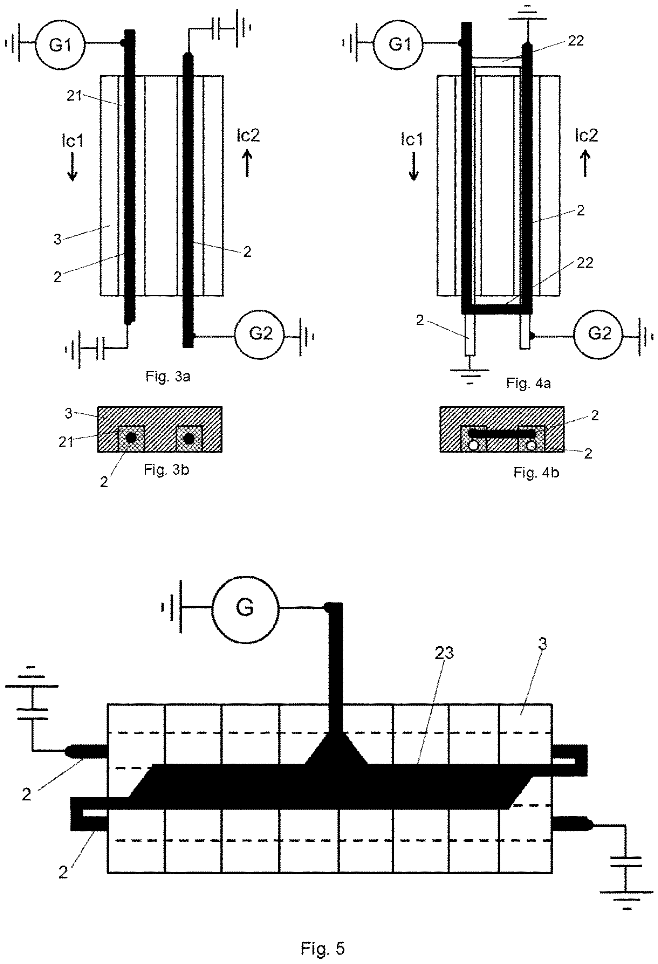

Die Figuren **Fig. 3a und Fig. 3b** zeigt schematisch eine Schaltungsvariante der ICP-Spulen nach dem Stand der Technik. Fig. 3a zeigt, dass die beiden Spulen (2) durch die beiden Generatoren G1 und G2 mit Hochfrequenz versorgt werden. Die Einspeisung erfolgt an den entgegengesetzten Enden, so dass die Ströme Ic1 und Ic2 entgegengesetzt verlaufen.

In Fig. 3b ist schematisch die Schnittansicht dargestellt.

Die Figuren **Fig. 4a und Fig. 4b** zeigen eine weitere Schaltungsvariante der ICP-Spulen nach dem Stand der Technik. Die Spulen (2) sind in den Nuten der Polschuhe ähnlich der in der in Fig. 1b dargestellten Weise angeordnet. Da die Spulen jedoch U-förmig ausgebildet und übereinander angeordnet sind, ergibt sich an der Stirnseite der Polschuhe jeweils eine Verbindungsleitung (22) zwischen den Schenkeln des "U". Aufgrund der U-Form verlaufen die Ströme (Ic1 und Ic2) in den beiden Schenkeln entgegengesetzt. Dies trifft auf die beiden übereinander angeordneten Spulen zu. Es ist nunmehr vom Phasenverhältnis der beiden Generatoren G1 und G2 abhängig, ob die Felder zwischen den beiden Spulen (2) im Gleich- oder im Gegentakt schwingen. Auch beliebige Phasenverschiebungen sind möglich. Bevorzugt sind die Generatoren (G1, G2) so geschaltet, dass die übereinander liegenden Schenkel unterschiedlicher Spulen (2) in der gleichen Richtung durchflossen werden.

**Fig. 5** zeigt schematisch, wie zwei Spulen (2) über eine Stromverteilerbrücke (23) (T-Verteiler) durch den Generator (G) an entgegengesetzten Enden mit Hochfrequenz versorgt werden, wobei die Hochfrequenzeinspeisung in der Mitte der Verteilerbrücke (23) angeschlossen wird, um asymmetrische Stromläufe zu vermeiden.

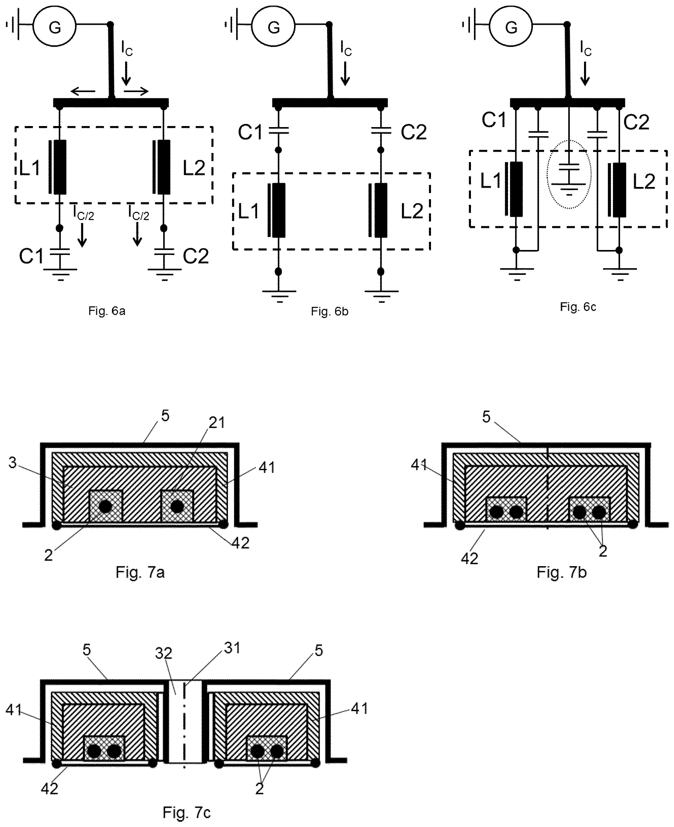

Die Figuren **Fig. 6a bis Fig. 6c** zeigen Beschaltungsvarianten der Spulen (L1, L2). Es gilt in allen drei Beschaltungsvarianten, dass die Spulen und die Kondensatoren jeweils gleich sind, d. h. L1=L1 und C1=C2. Auf diese Weise entstehen symmetrische Schwingkreise.

Die Figuren **Fig. 7a bis Fig. 7c** zeigen schematisch Teile der erfindungsgemäßen Konstruktion im Schnitt. Während Fig. 7a und Fig. 7b linear ausgedehnt sind, ist die Anordnung aus Fig. 7c rotationssymmetrisch. Um die aus den Figuren 2a bis 2c bekannte Konstruktion herum, ist jeweils eine Dunkelraumabschirmung (5) angeordnet.

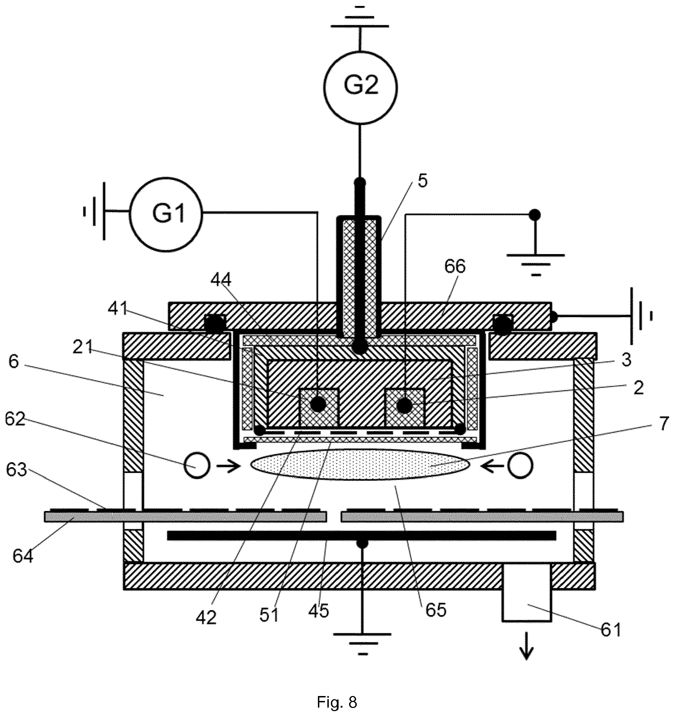

Figur **Fig. 8** zeigt die erfindungsgemäße Vorrichtung schematisch in Ihrer Gesamtheit (mit Ausnahme der Multipolanordnungen) in einer Behandlungskammer (6). Die Vorrichtung zur induktiven Energieeinspeisung in das Plasma (7) besteht im Wesentlichen aus zwei geraden Leitern (siehe auch Fig.3a), die der Einfachheit halber weiter als Spulen (2) bezeichnet werden sollen. Die Zuführung der HF-Energie des Generators G1 erfolgt analog zu der Darstellung in Fig. 5 bzw. Figuren. 6a, 6b, und 6c über einen nicht dargestellten T-Verteiler (23). Die Spulen (2) sind in keramische Isolationskörper (21) und in diesen dann in die Nuten der Polschuhe (3) eingebettet. Um die Polschuhe (3) herum ist die Umhüllung (41) ausgeführt, die in Richtung des Plasmaraumes mit dem Plasma (7) durch den faradayschen Schild (42) abgeschlossen wird. Der faradaysche Schild (42) und die Umhüllung (41) stehen in elektrisch leitender Verbindung. Um die Umhüllung (41) herum ist eine Isolationsschicht (44) (elektrisch isolierend) ausgebildet, die ihrerseits mit Ausnahme der Nutseite von der Dunkelraumabschirmung (5) eingehüllt ist. Als Isolationsschicht kommen z.B. Platten aus Quarzglas, Aluminiumoxidkeramiken oder auch andere Isoliermaterialien bzw. auch Vergussmassen in Frage, die neben den elektrischen Isoliereigenschaften möglichst auch noch einen niedrigen Eigenverbrauch der durch den Generator G2 eingesetzten HF-Leistung verursachen. Das Ausfüllen des Zwischenraumes zwischen der Umhüllung (41) und der Dunkelraumabschirmung (5) mit einer Isolationsschicht (44) aus isolierenden Materialien ist zwar üblich, der Betrieb kann aber auch ohne diese Isolationsschicht erfolgen. Dazu muss der Abstand zwischen der Umhüllung (41) und der Dunkelraumabschirmung entsprechend dem bekannten Paschengesetz ausgelegt werden, um eine Plasmazündung im Zwischenraum zu vermeiden. Die Nutseite der Dunkelraumabschirmung (5) weist hier noch eine Quarzscheibe (51) als Verschmutzungsschutz auf.

Vor der Quarzscheibe befindet sich der Plasmaraum (65), durch den in der vorliegenden Darstellung die Substratscheiben (63) als zu bearbeitende Materialien hindurch bewegt werden. Sie liegen dabei auf den Substratträgern (64). Das Plasma (7) wird aus den Gaszuführungen (62) beiderseits des Plasmaraums (65) gespeist.

Die Vorrichtung weist zwei HF-Generatoren (G1, G2) auf. Der Generator (G1) speist seine Hochfrequenz über einen T- Verteiler (23) (nicht dargestellt) direkt in die jeweilige Seite der Spulen (2) ein. Die der Einspeisung gegenüberliegende Seite der Spulen (2) werden direkt mit der Masse verbunden oder auch alternativ über einen zusätzlichen Kondensator auf Masse gelegt. Siehe dazu auch die Fig. 6a und 6b. Der zweite Generator (G2) ist mit der Umhüllung (41), und über diese leitend mit dem faradayschen Schild (42) verbunden. Die Gegenelektrode (45) ist unterhalb der bewegten Substrate (63) angeordnet. Sie bildet gemeinsam mit der Umhüllung (41) und dem faradayschen Schild (42) eine Kondensatoranordnung. Diese wird vom Fachmann auch als Parallel-Plattenanordnung bezeichnet. Die Gegenelektrode (45) wird in der vorliegenden Ausführungsform auf Massepotential gelegt. In einigen Anwendungsfällen kann die Gegenelektrode auch an einen zusätzlichen Generator angeschlossen werden um einen Mischfrequenzbetrieb mit der kapazitiv gekoppelten Plasmaerzeugung, die durch Generator (G2) gespeist wird, nutzen zu können. Für den Mischfrequenzbetrieb können Generatoren verwendet werden, die entweder Gleichspannungen oder gepulste Gleichspannungen oder aber auch Frequenzen im Bereich von wenigen Hz bis etwa 27 MHz liefern können. Vermittels des Mischfrequenzbetriebes kann die Bewegung der Ionen im Plasma (7) in gewünschter Weise beeinflusst werden, so dass eine verbesserte Behandlung der Substrate (63) möglich ist. Die Behandlungskammer (6) liegt auf Massepotential. Dadurch ist es möglich, dass die kapazitiv gekoppelte Plasmaanregung durch den Generator (G2) auch ohne Gegenelektrode (45) betrieben werden kann. Die Behandlungskammer (6) selbst wirkt dann als Gegenelektrode im Bezug zum faradayschen Schild (42). Analog zum Mischfrequenzbetrieb an der Gegenelektrode (45) kann auch an der Einspeisung des Generators (G2) an der erfindungsgemäßen Vorrichtung (1) ein zusätzlicher Generator angeschlossen werden, um einen Mischfrequenzbetrieb zu ermöglichen. In der Behandlungskammer (6) wird mittels einer Vakuumpumpe (nicht dargestellt) über einen entsprechenden Anschluss (61) ein Unterdruck erzeugt. Die erfindungsgemäße Vorrichtung ist mittels eines Flansches (66) in einer Durchführung der Wandung der Behandlungskammer (6) befestigt.

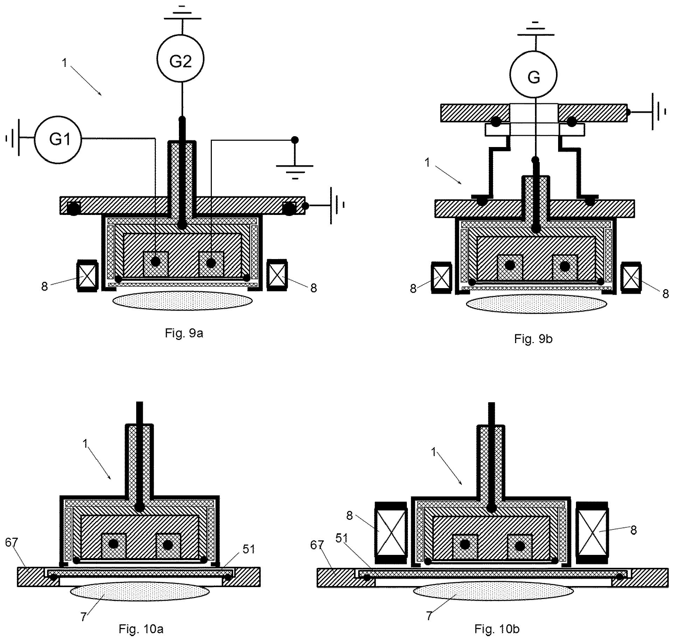

Die Figuren **Fig. 9a und Fig. 9b** zeigen schematisch zwei Montagevarianten der erfindungsgemäßen Vorrichtung. Die Vorrichtung verfügt hier über zwei Multipolanordnungen (8), die parallel zu den Spulen und benachbart zu der erfindungsgemäßen Vorrichtung verlaufen.

Fig. 9b zeigt hierbei insbesondere eine Einbauvariante. Die erfindungsgemäße Vorrichtung wird über ein vakuumdichtes Zwischenstück bis zum Behandlungsbereich der Substrate geführt und umschließt dabei alle notwendigen Medienzuführungen. Dadurch können die notwendigen Medienzuführung und insbesondere auch die elektrische Leistungsversorgung unter Atmosphärenbedingungen verlegt werden. Je nach Gestaltung des Zwischenstückes bzw. auch mehrerer Zwischenstücke kann damit die erfindungsgemäße Vorrichtung sehr flexibel den Gegebenheiten in der Prozesskammer angepasst werden. Diese Zwischenstücke können fest fixierte Baugruppen oder beispielsweise auch flexible vakuumtaugliche Schläuche sein. Im Falle des Einsatzes von flexiblen Zwischenstücken kann die erfindungsgemäße Vorrichtung (1) mit Hilfe entsprechender Antriebssysteme auch gegenüber den Substraten definiert bewegt werden.

Die Figuren **Fig. 10a und Fig. 10b** zeigen schematisch, wie die erfindungsgemäße Vorrichtung (1) außerhalb der Behandlungskammer (6) an deren Wandung (67) angeordnet werden kann. In der metallischen Wandung ist eine entsprechende Öffnung vorzusehen, die von der Quarzscheibe (51) auf der Nutseite der Dunkelraumabschirmung verschlossen wird.

In Figur 10b sind zusätzlich zwei magnetische Multipolanordnungen (8) vorgesehen, die sich ebenfalls außerhalb der Behandlungskammer 6 befinden und die parallel zu den Spulen verlaufen. Die Magnetfelder der Multipolanordnungen (8) treten auch durch die dielektrische Quarzscheibe (51) in die Behandlungskammer ein und wirken auf das Plasma (7).

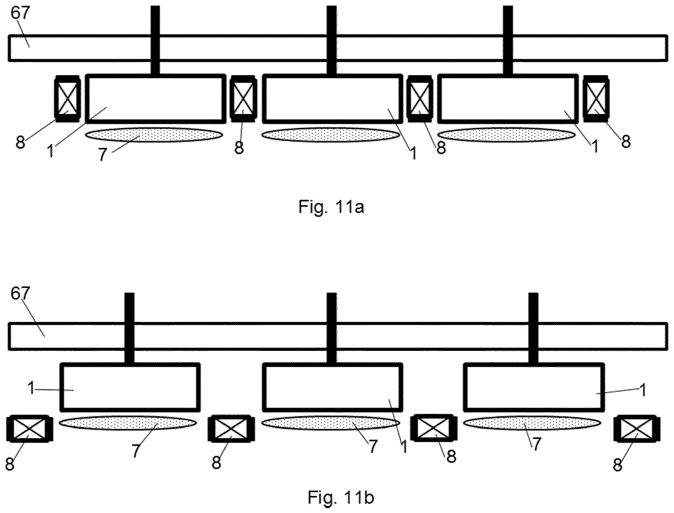

Die Figuren Fig. **11a und Fig. 11b** zeigen schematisch Anordnungsvarianten der magnetischen Multipolanordnungen (8). Die erfindungsgemäße Vorrichtung (1) (dargestellt ohne die Gegenelektrode) befindet sich hinter der Wandung (67) der Behandlungskammer in deren Inneren. Die magnetischen Multipolanordnungen sind in Fig. 11a neben der erfindungsgemäßen Vorrichtung (1) angeordnet und wirken von dort aus auf das Plasma (7) ein. In Fig. 11b sind die magnetischen Multipolanordnungen neben dem Plasma angeordnet. Sie befinden sich damit quasi im Plasmaraum. Die Feldwirkung auf das Plasma (7) ist wegen des geringeren Abstandes stärker, die Verschmutzung bzw. Abnutzung jedoch auch.

Vorteilhaft wird zwischen zwei benachbarten erfindungsgemäßen Vorrichtungen nur eine magnetische Multipolanordnung benötigt, die nach beiden Seiten wirkt.

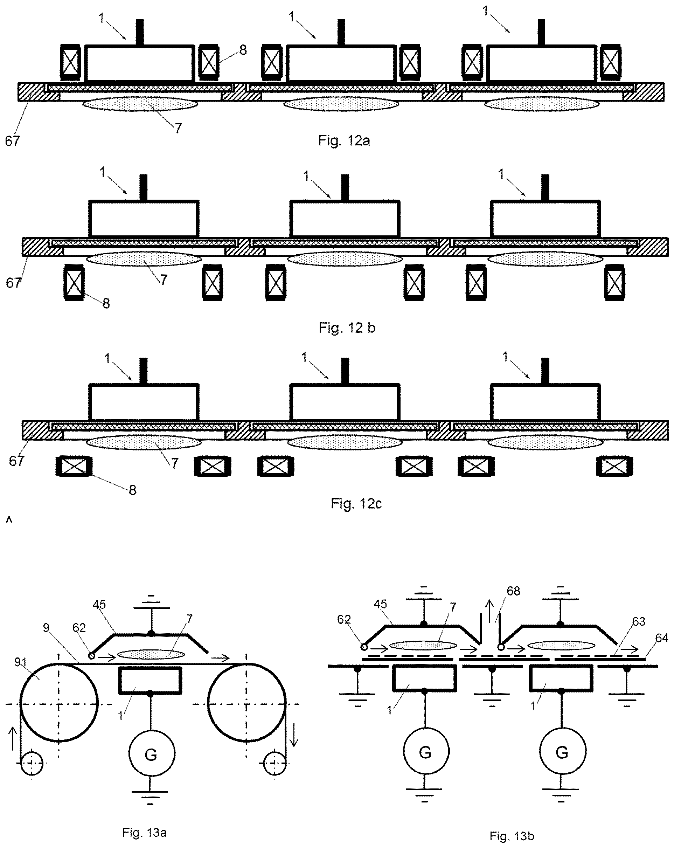

**Fig. 12a bis Fig. 12c** zeigen schematisch Anordnungsvarianten der magnetischen Multipolanordnungen im Verhältnis zur erfindungsgemäßen Vorrichtung (1). Während sich in Fig. 12a sowohl erfindungsgemäße Vorrichtung als auch die Multipolanordnung außerhalb der Behandlungskammer befinden, und ihre Felder lediglich durch die dielektrische Abdeckung in das Innere der Behandlungskammer reichen, ist in Fig. 12b und Fig. 12c die erfindungsgemäße Vorrichtung außerhalb und die Mulipolanordnung innerhalb der Behandlungskammer angeordnet. Die Figuren Fig. 12b und Fig. 12c unterscheiden sich vorwiegend in der Ausrichtung der magnetischen Polschuhe in den Multipolanordnungen. Die magnetischen Polschuhe in Fig.12b sind senkrecht zur Wandung (67) orientiert und in der Fig.12c parallel. Die Orientierung der magnetischen Polschuhe beeinflusst dabei die Überlagerung und Ausbildungsform des Magnetfeldes der Multipolanordnung im Bezug zum ausgebildeten ICP-Plasma. In besonderen Fällen kann auch eine abweichende Winkelstellung der magnetischen Polschuhe zwischen senkrecht oder parallel zur Wandung (67) vorteilhafter sein.

**Fig. 13a und Fig. 13b** zeigen schematisch Einsatzvarianten der erfindungsgemäßen Vorrichtung (1). In Fig. 13a wird die Vorrichtung (1) zur Beschichtung von Folien eingesetzt. Zur Vereinfachung ist lediglich der Generator (G) für die kapazitive Energieeinkopplung gezeigt. Das Plasma wird auf der der Vorrichtung abgewandten Seite der Folie (9) erzeugt. Zwischen Folie (9) und Gegenelektrode (45) wird aus der Gaseinleitung (62) das Arbeitsgas eingeblasen und in Plasma (7) umgewandelt. Über die Umlenkrolle (91) wird fortgesetzt Folie zur Behandlung nachgeliefert, die nach der Behandlung über eine äquivalente Umlenkrolle zur Aufwicklung weiter transportiert wird. Vorteilhaft in Fig.13a und Fig.13b ist, dass die Folie bzw. die Carrier die Vorrichtungen quasi permanent abdecken. Im Falle der Plasmabeschichtung wird die Vorrichtung dadurch sehr Wartungsfreundlich.

In Fig. 13b sind zwei Plasmaquellen nebeneinander angeordnet. Restgas wird über die Gasabführung (68) zwischen den beiden Gegenelektroden (45) abgeführt. Die Substrate (63) werden auf den Substratträgern (64) nacheinander in die beiden hintereinandergeschalteten Behandlungsräume (hier angedeutet durch die Krümmung der Gegenelektroden (45)) bewegt und der Behandlung unterzogen.

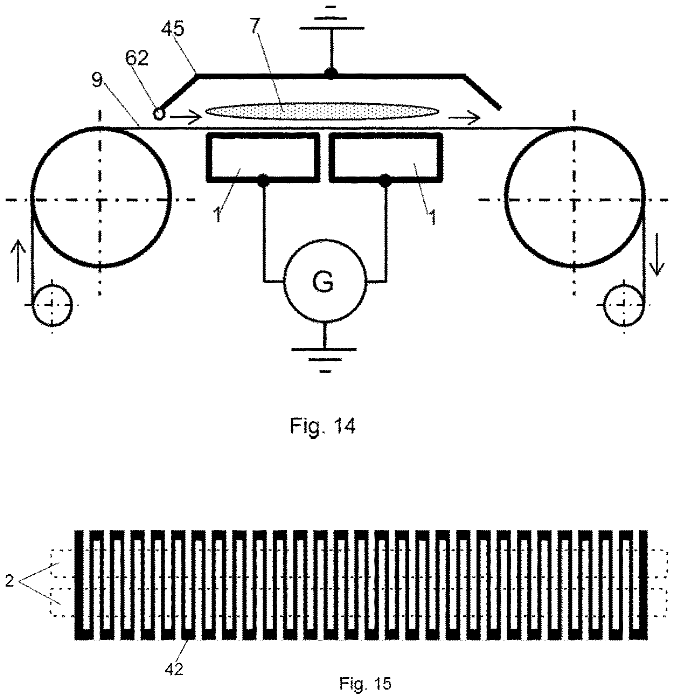

**Fig. 14** zeigt schematisch eine weitere Variante des Einsatzes der erfindungsgemäßen Vorrichtung. Die beiden Plasmaquellen (1) können dabei beispielsweise auch aus einem symmetrischen Generator G mit Energie für die kapazitive Einkopplung versorgt werden (die induktive Einkopplung mit Generator etc. ist vorhanden, wurde jedoch nicht dargestellt). In einer weiteren Variante werden die beiden Plasmaquellen (1) auch mit bipolaren oder unipolaren gepulsten Gleichspannungen betrieben. Auch ist eine gleichzeitige Leistungsversorgung von mehreren Plasmaquellen (1) mit nur einem Generatorsystem eine übliche Herangehensweise um die Anzahl der kostspieligen Generatoren und Anpassungsnetzwerke zu reduzieren.

Die beiden Vorrichtungen (1) erzeugen ein gemeinsames Plasma (7), mit dem die Folie (9) bearbeitet wird.

**Fig. 15** zeigt schematisch einen faradayschen Schirm (42), der eingesetzt wird, um die leitfähige Umhüllung auf der Nutseite, in Richtung des Plasmaraumes abzuschließen. Die mäanderförmige Struktur weist Schlitze auf, die parallel zu den Feldlinien der ICP-Spulen (2) (schematisch gestrichelt dargestellt) verlaufen. Durch die mäanderförmige Struktur wird vorteilhaft das Entstehen von Wirbelströmen in dem faradayschen Schirm (42) reduziert.

### Ausführungsbeispiel

Anhand der Darstellung von Figur Fig. 8 wird eine Ausführungsform der erfindungsgemäßen Plasmavorrichtung detailliert dargestellt, ohne die Erfindung auf diese Ausführungsform beschränken zu wollen.

Die erfindungsgemäße Vorrichtung ist in einer Behandlungskammer (6) nach dem Stand der Technik angeordnet, wie sie für die Durchlaufverfahren der Solarzellentechnik üblicherweise genutzt werden. Die Vorrichtung zur induktiven Energieeinspeisung in das Plasma (7) weist zwei Spulen auf, die als einzelne gerade Leiter ausgeführt sind. Siehe auch Fig.3. Die Spulen weisen eine Länge von ca. 100cm bei einem Abstand zueinander von ca. 35mm auf. Die Spulen bestehen aus Kupferrohren mit einem Rohrdurchmesser von 8mm. Die Zuführung der HF-Energie des Generators G1 erfolgt analog Fig.5. Bei dem Generator G1 handelt es sich um einen HF- Generator, der normalerweise über ein Anpassungsnetzwerk (nicht dargestellt) mit der erfindungsgemäßen Vorrichtung verbunden ist. Der Generator G1 gibt eine Hochfrequenz von 4MHz ab. Aufgrund der gewählten Abmessungen der Vorrichtung (1) hat der HF-Generator G1 eine HF-Leistung von ca. 5kW. Die Spulen (2) sind in keramische Isolationskörper (21) eingebettet. Die Abmessungen dieser Isolationskörper sind der Nutgeometrie der verwendeten Polschuhe angepasst und betragen im Querschnitt ca.: 13mm x 32mm. Die Isolationskörper sind ihrerseits dann in die Nuten der Polschuhe (3) eingebettet. Als Polschuhe (3) werden handelsübliche E70- Kerne eingesetzt. Die Polschuhe bestehen aus dem Ferritmaterial 4F1 (Fa. Ferroxcube). Die Polschuhe haben eine Breite=71mm eine Höhe=33mm und eine Länge=32mm. Es sind 30 einzelne Polschuhe hintereinander angeordnet, die so eine gemeinsame Gesamtlänge von ca. 960mm ergeben. Um die Polschuhe (3) herum ist die Umhüllung (41) ausgeführt, die in Richtung des Plasmaraumes mit dem Plasma (7) durch den faradayschen Schild (42) abgeschlossen wird. Die Umhüllung besteht aus einem Frästeil aus einer Aluminiumlegierung, dass eine umlaufende Wandstärke von ca. 15mm aufweist. Zur Abführung der elektrischen Verlustleistungen der Polschuhe wird die Umhüllung wassergekühlt. Zur Wärmeableitung zwischen den Polschuhen und der Umhüllung wird eine wärmeleitende Vergussmasse, Folie oder Kleber verwendet. Der faradaysche Schild (42) und die Umhüllung (41) stehen in elektrisch leitender Verbindung. Der faradaysche Schild (42) besteht z.B. aus einem nichtmagnetisierbaren Edelstahlblech und verschließt den gesamten Öffnungsbereich der Umhüllung. Die Materialstärke beträgt ca. 0.5mm. Der faradaysche Schild weist an den Längsseiten wechselseitige Schlitze mit einer Breite von 0.1 bis 0.5mm und einem Abstand von ca.10mm auf. Um die Umhüllung (41) herum ist eine Isolationsschicht (44) (elektrisch isolierend) ausgebildet, die ihrerseits mit Ausnahme der Nutseite von der Dunkelraumabschirmung (5) eingehüllt ist. Die Isolierschicht besteht bevorzugt aus zwei Lagen von Platten aus Aluminiumoxidkeramik, die ineinander verschachtelt angeordnet sind, um keinen durchgehenden Spalt zwischen Umhüllung (41) und Dunkelraumabschirmung (5) zuzulassen. Die Gesamtdicke der Lagenanordnung beträgt ca. 8 bis 12mm. Die Nutseite der Dunkelraumabschirmung (5) weist hier noch eine Quarzscheibe (51) mit einer Stärke von ca. 4mm als Verschmutzungsschutz auf.

Vor der Quarzscheibe befindet sich der Plasmaraum (65), durch den in der vorliegenden Darstellung die Substratscheiben (63) als zu bearbeitende Materialien hindurch bewegt werden. Sie liegen dabei auf den Substratträgern (64). Das Plasma (7) wird aus den Gaszuführungen (62) beiderseits des Plasmaraums (65) mit Prozessgasen gespeist.

Die Vorrichtung weist zwei HF-Generatoren (G1, G2) auf. Der Generator (G1) vom Typ Cesar(Fa. AE) speist seine Hochfrequenz von z.B. 4MHz über eine entsprechende Zuführung (nicht dargestellt) direkt in die Spulen (2) ein. Der zweite Generator (G2) (Typ Cesar, Fa. AE) ist mit der Umhüllung (41), und über diese leitend mit dem faradayschen Schild (42) verbunden. Die eingespeiste Hochfrequenz beträgt hier 13.56 MHz. Die Gegenelektrode (45) zur kapazitiven Ankopplung der Masse ist unterhalb der bewegten Substrate (63) angeordnet. Als Gegenelektrode (45) wird eine Strahlungsheizung (nicht dargestellt!) eingesetzt, deren Strahlungsfläche wiederum aus einem Edelstahlblech besteht das sich auf Massepotential befindet. Die Strahlungsfläche folgt dabei in der Breite ca. der Geometrie der Bearbeitungsspur der Substratträger (64) und erstreckt sich in der Länge etwa zwischen den Transportöffnungen der Behandlungskammer (6). Der Substratträger (64) hat die Abmessungen 111 0mm x 756 mm. Die Gegenelektrode (45) bildet gemeinsam mit der Umhüllung (41) und dem faradayschen Schild (42) eine Kondensatoranordnung. Die Höhe der angelegten Generatorleistung des Generators G2 beeinflusst dabei im Wesentlichen die energetischen Bedingungen der auf das Substrat auftreffenden Ionen aus dem Plasma (7). Die Anzahl der pro Fläche auftreffenden Ionen werden vorwiegend durch die eingesetzte HF-Leistung des Generators G1 bestimmt. Damit ist eine sehr flexible Einstellung der Behandlungsbedingungen bzw. der Qualität der Bearbeitung der Substrate (63) möglich.

In der Behandlungskammer (6) wird mittels eines Vakuumpumpsystems (nicht dargestellt) über einen entsprechenden Anschluss (61) ein Unterdruck von ca. 1 x 10⁻⁶ mbar erzeugt. Mit dem Einlassen von Prozessgasen kann ein typischer Arbeitsdruck innerhalb der Behandlungskammer (6) von ca. 5 x 10⁻⁴mbar bis ca. 0.1mbar eingestellt werden. Die erfindungsgemäße Vorrichtung ist mittels eines Flansches (66) in einer Durchführung der Wandung der Behandlungskammer (6) befestigt.

### Bezugszeichenliste

- 1: erfindungsgemäße Vorrichtung
- 2: ICP-Spule
- 21: keramischer Isolierkörper
- 22: Verbindung der beiden Schenkel einer U-förmigen Spule
- 23: Stromverteilerbrücke zur symmetrischen Stromversorgung zweier Spulen
- 3: magnetische Polschuhanordnung
- 31: Symmetrieachse der rotationssymmetrischen magnetischen Polschuhanordnung
- 32: rotationssymmetrischer Hohlraum in der Polschuhanordnung
- 41: leitfähige Umhüllung im Bereich der Polschuhanordnung
- 42: faradayscher Schirm
- 43: leitfähige Verbindung zwischen faradayschem Schirm und leitfähiger Umhüllung
- 44: nichtleitende Isolationsschicht um die leitfähige Umhüllung
- 45: Gegenelektrode zur kapazitiven Einkopplung
- 5: Dunkelraumabschirmung
- 51: Quarzscheibe auf der Nutseite der Dunkelraumabschirmung
- 6: Behandlungskammer
- 61: Vakuumabsaugung
- 62: Gaszuführung für Plasmaerzeugung
- 63: zu behandelndes Substrat
- 64: Substratträger zum Transport durch die Behandlungskammer
- 65: Plasmaraum
- 66: Flansch zur Befestigung der Vorrichtung in der Wandung der Behandlungskammer
- 67: Wandung der Behandlungskammer
- 68: Gasabsaugung
- 7: Plasma
- 8: magnetische Multipolanordnungen
- 9: Folie
- 91: Umlenkrolle für Folie
- C1: Kondensator eines ersten Schwingkreises
- C2: Kondensator eines zweiten Schwingkrieses
- G, G1: Hochfrequenzgenerator
- G2: Hochfrequenzgenerator
- Ic1: Stromrichtung in der Spule 1
- Ic2: Stromrichtung in der Spule 2
- L1: Spule eines ersten Schwingkreises
- L2: Spule eines zweiten Schwingkreise

## Patentansprüche

1. Vorrichtung (1) zur Plasmaerzeugung, mindestens eine induktiven Vorrichtung und mindestens eine kapazitive Vorrichtung zur Einkopplung von Energie in ein Plasma (7) in einem Plasmaraum (65) aufweisend, wobei die mindestens eine induktive Vorrichtung und die mindestens eine kapazitive Vorrichtung getrennt voneinander durch unterschiedliche Frequenzgeneratoren (G1, G2) oder aber durch einen gemeinsamen Frequenzgenerator (G) mit Energie versorgt werden, **dadurch gekennzeichnet, dass** die induktive Vorrichtung von einer leitfähigen Umhüllung (41) umgeben ist, die auf der Plasmaseite durch einen faradayschen Schirm (42) abgeschlossen wird, mit dem sie leitfähig verbunden ist und dass die leitfähige Umhüllung (41) leitfähig mit einem Frequenzgenerator (G2) verbunden ist und dass leitfähige Umhüllung (41), faradayscher Schirm (42) sowie mindestens eine Gegenelektrode (45) die kapazitive Vorrichtung bilden.

2. Vorrichtung nach Anspruch 1, **dadurch gekennzeichnet, dass** die induktive Vorrichtung mindestens eine Spule (2) aufweist, die mit einem Frequenzgenerator (G, G1) leitend verbunden ist und in einer Nut (33) eines magnetischen Polschuhes (3) angeordnet ist.

3. Vorrichtung nach Anspruch 2, **dadurch gekennzeichnet, dass** die mindestens eine Spule (2) in der Nut (33) des magnetischen Polschuhs (3) von einem keramischen Isolierkörper (21) umgeben ist.

4. Vorrichtung nach einem der vorhergehenden Ansprüche, **dadurch gekennzeichnet, dass** die leitfähige Umhüllung (41) auf den nicht dem Plasma (7) zugewandten Seiten mit einer Dunkelraumabschirmung (5) ausgestattet ist, von der sie elektrisch isoliert ist.

5. Vorrichtung nach Anspruch 4, **dadurch gekennzeichnet, dass** die Dunkelraumabschirmung (5) auf der dem Plasma (7) zugewandten Seite mit einer dielektrischen Abdeckung verschlossen ist.

6. Vorrichtung nach einem der vorhergehenden Ansprüche, **dadurch gekennzeichnet, dass** die Gegenelektrode (45) der kapazitiven Vorrichtung sich gegenüber der dielektrischen Abdeckung auf der gegenüberliegenden Seite des Plasmaraumes (65) befindet.

7. Vorrichtung nach Anspruch 6, **dadurch gekennzeichnet, dass** zwei kapazitive Vorrichtungen von demselben Frequenzgenerator (G) mit Energie beaufschlagt werden und eine gemeinsame Gegenelektrode (45) nutzen.

8. Vorrichtung nach einem der vorhergehenden Ansprüche, **dadurch gekennzeichnet, dass** neben der Vorrichtung (1) zur Plasmaerzeugung oder neben dem Plasmaraum (65) und parallel zum Verlauf der mindestens einen Spule (2) eine oder zwei magnetische Multipolanordnungen (8) angeordnet sind, wobei im Falle von zwei Multipolanordnungen (8) sich diese auf entgegengesetzten Seiten der Spule (2) befinden.

9. Vorrichtung nach Anspruch 8, **dadurch gekennzeichnet, dass** die Vorrichtung (1) an der Außenseite einer Behandlungskammer (6) und durch eine dielektrische Scheibe (51) von deren Innerem getrennt angeordnet ist und die magnetischen Multipolanordnungen (8) innerhalb oder außerhalb der Behandlungskammer (6) angeordnet sind.

10. Vorrichtung nach Anspruch 9, **dadurch gekennzeichnet, dass** die dielektrische Scheibe (51) mit der dielektrischen Abdeckung identisch ist.

11. Vorrichtung nach Anspruch 8, **dadurch gekennzeichnet dass** die Vorrichtung (1) an der Innenseite einer Behandlungskammer (6) angeordnet ist.

12. Verfahren zum Betrieb einer Vorrichtung (1) nach einem der Ansprüche 1 bis 11, **dadurch gekennzeichnet, dass** zusätzlich zur HF-Leistungsversorgung der induktiven Vorrichtung, für eine kurze definierte Zeit, eine erhöhte HF-Spannung an die kapazitive Vorrichtung angelegt wird, und die kapazitive Kopplung so als Zündhilfe für das induktiv gekoppelte Plasma (7) dient.

## Claims

1. Device (1) for plasma generation having at least one inductive device and at least one capacitive device for coupling energy into a plasma (7) in a plasma chamber (65), wherein the at least one inductive device and the at least one capacitive device are supplied with energy separately from one another by different frequency generators (G1, G2) or by a common frequency generator (G), **characterized in that** the inductive device is surrounded by a conductive enclosure (41) that is terminated on the plasma side by a Faraday shield (42), to which said enclosure is connected in a conductive manner, and that the conductive enclosure (41) is connected in a conductive manner to a frequency generator (G2) and that the conductive enclosure (41), the Faraday shield (42) and at least one counter-electrode (45) form the capacitive device.

2. Device according to claim 1, **characterized in that** the inductive device has at least one coil (2) that is connected in a conductive manner to a frequency generator (G, G1) and that the at least one coil is arranged in a groove (33) of a magnetic pole shoe (3).

3. Device according to claim 2, **characterized in that** the at least one coil (2) in the groove (33) of the magnetic pole shoe (3) is surrounded by a ceramic insulation element (21).

4. Device according to one of the preceding claims, **characterized in that** the conductive enclosure (41) is equipped with a dark space shield (5) from which it is electrically insulated on the sides that are not turned towards the plasma (7).

5. Device according to claim 4, **characterized in that** the dark space shield (5) on the side turned towards the plasma (7) is closed up with a dielectric cover.

6. Device according to one of the preceding claims, **characterized in that** the counter-electrode (45) of the capacitive device is on the opposite side of the plasma chamber (65) with respect to the dielectric cover.

7. Device according to claim 6, **characterized in that** two capacitive devices are loaded with energy by the same frequency generator (G) and use a common counter-electrode (45).

8. Device according to one of the preceding claims, **characterized in that** one or two magnetic multi-pole arrangements (8) are located next to the device (1) for plasma generation or next to the plasma chamber (65) and in parallel with the at least one coil (2), wherein, in the case of two multi-pole arrangements (8), they are located on opposite sides of the coil (2).

9. Device according to claim 8, **characterized in that** the device (1) is arranged on the outside of a processing chamber (6) and is separated from the interior by a dielectric disk (51), and the magnetic multi-pole arrangements (8) are arranged inside of or outside of the processing chamber (6).

10. Device according to claim 9, **characterized in that** the dielectric disk (51) is identical to the dielectric cover.

11. Device according to claim 8, **characterized in that** the device (1) is arranged on the inside of a processing chamber (6).

12. Method for operating a device (1) according to one of the claims 1 to 11, **characterized in that** an increased HF voltage is applied to the capacitive device for a short, defined period of time in addition to the HF power supply of the inductive device, and the capacitive coupling serves **in that** way as an ignition aid for the inductively coupled plasma (7).

## Revendications

1. Dispositif (1) destiné à former un plasma, comportant au moins un dispositif inductif et au moins un dispositif capacitif pour injecter de l'énergie dans un plasma (7), dans une chambre à plasma (65), l'au moins un dispositif inductif et l'au moins un dispositif capacitif étant alimentés en énergie séparément l'un de l'autre par différents générateurs de fréquences (G1, G2) ou encore par un générateur de fréquences (G) commun, **caractérisé en ce que** le dispositif inductif est entouré d'une enveloppe (41) conductrice, que l'on ferme du côté plasma par un blindage de Faraday (42), avec lequel est elle reliée de manière conductrice et **en ce que** l'enveloppe (41) conductrice est reliée de manière conductrice avec un générateur de fréquences (G2) et **en ce que** l'enveloppe (41) conductrice, le blindage de Faraday (42) ainsi qu'au moins une contre-électrode (45) forment le dispositif capacitif.

2. Dispositif selon la revendication 1, **caractérisé en ce que** le dispositif inductif comporte au moins une bobine (2) qui est reliée de manière conductrice avec un générateur de fréquences (G, G1) et qui est placée dans une rainure (33) d'une pièce polaire magnétique (3).

3. Dispositif selon la revendication 2, **caractérisé en ce que** dans la rainure (33) de la pièce polaire magnétique (3), l'au moins une bobine (2) est entourée d'un corps isolant céramique (21).

4. Dispositif selon l'une quelconque des revendications précédentes, **caractérisé en ce que** sur les côtés qui ne font pas face au plasma (7), l'enveloppe (41) est équipée d'un écran chambre noire (5) par rapport auquel elle est électriquement isolée.

5. Dispositif selon la revendication 4, **caractérisé en ce que** sur le côté qui fait face au plasma (7), l'écran chambre noire (5) est fermé par un couvercle diélectrique.

6. Dispositif selon l'une quelconque des revendications précédentes, **caractérisé en ce que** la contre-électrode (45) du dispositif capacitif se trouve au vis-à-vis du couvercle diélectrique, sur le côté opposé de la chambre à plasma (65).

7. Dispositif selon la revendication 6, **caractérisé en ce que** deux dispositifs capacitifs sont exposé à une énergie par le même générateur de fréquences (G) et utilisent une contre-électrode (45) commune.

8. Dispositif selon l'une quelconque des revendications précédentes, **caractérisé en ce qu'**à côté du dispositif (1) de formation du plasma ou à côté de la chambre à plasma (65) et à la parallèle du trajet de l'au moins une bobine (2) (est) sont placé(s) un ou deux agencements multipolaires (8) magnétiques, dans le cas de deux agencements multipolaires (8), ceux-ci se trouvant sur des côtés opposés de la bobine (2).

9. Dispositif selon la revendication 8, **caractérisé en ce que** le dispositif (1) est placé sur la face extérieure d'une chambre de traitement (6) en étant séparé par un disque diélectrique (51) de l'intérieur de celle-ci et les agencements multipolaires (8) magnétiques sont placés à l'intérieur ou à l'extérieur de la chambre de traitement (6).

10. Dispositif selon la revendication 9, **caractérisé en ce que** le disque diélectrique (51) est identique au couvercle diélectrique.

11. Dispositif selon la revendication 8, **caractérisé en ce que** le dispositif (1) est placé sur la face intérieure d'une chambre de traitement (6).

12. Procédé destiné à faire fonctionner un dispositif (1) selon l'une quelconque des revendications 1 à 11, **caractérisé en ce qu'**en supplément de l'alimentation énergétique HF du dispositif inductif, pour un bref laps de temps défini, une tension HF élevée est appliquée au dispositif capacitif et l'accouplement capacitif sert ainsi d'aide à l'allumage pour le plasma (7) couplé par induction.
